# EUROPÄISCHE PATENTSCHRIFT

(11) **EP 2 537 038 B1**
(45) Veröffentlichungstag und Bekanntmachung des Hinweises auf die Patenterteilung: **14.08.2019**
(21) Anmeldenummer: 11700611.4
(22) Anmeldetag: 12.01.2011
(51) Int. Cl.: G01R 1/067

(54) **TASTKOPF-SYSTEM MIT KOMPENSATIONSNETZWERK**
PROBE SYSTEM WITH COMPENSATING NETWORK
SYSTÈME DE SONDE À RÉSEAU DE COMPENSATION

(30) Priorität: 26.08.2010 DE 102010035456; 04.03.2010 DE 102010010100; 19.02.2010 DE 102010008621
(43) Veröffentlichungstag der Anmeldung: 26.12.2012
(73) Patentinhaber: Rohde & Schwarz GmbH & Co. KG, 81671 München (DE)
(72) Erfinder: PESCHKE, Martin, 81549 München (DE); BONNET, Cédric, 81667 München (DE)
(74) Vertreter: Körfer, Thomas
(86) Internationale Anmeldenummer: PCT/EP2011/000102
(87) Internationale Veröffentlichungsnummer: WO 2011/101071

(56) Entgegenhaltungen:
- EP-A2- 1 605 588
- US-A- 4 743 839
- US-B1- 6 483 284
- US-B1- 6 822 463
- US-B2- 6 856 126
- "DIFFERENTIAL PROBE", ELEKTOR, CANTERBURY, GB, Bd. 20, Nr. 228, 1. Dezember 1994 (1994-12-01), Seite 98, XP000473058, ISSN: 0268-4519
- KENICHIRO HAGA ET AL: "High-frequency Active Probe for Oscilloscope with Optimum Design for the SICE-ICASE International Joint Conference 2006 (SICE-ICCAS 2006) Oct. 18-21, 2006 in Bexco, Busan, Korea", SICE-ICCAS 2006 INTERNATIONAL JOINT CONFERENCE, IEEE, PISCATAWAY, NJ, USA, 1. Oktober 2006 (2006-10-01), Seiten 5264-5267, XP031050478, ISBN: 978-89-950038-4-8
- TEKTRONIX: "Z - Active : A New High Performance Probe Architecture", ANNOUNCEMENT TEKTRONIX, XX, XX, 1. Oktober 2004 (2004-10-01), Seiten 1-24, XP002397542,

## Beschreibung

Die Erfindung betrifft ein Tastkopf-System, beispielsweise für ein Oszilloskop. Das Tastkopf-System kann aber auch für andere Messgeräte, beispielsweise einen SpektrumAnalysator oder einen Netzwerkanalysator eingesetzt werden.

Aus dem Stand der Technik sind schon verschiedene Tastkopf-Systeme mit unterschiedlichen Verstärkerarchitekturen bekannt. Beispielsweise zeigt die US 6,856,126 B2 eine Verstärkerarchitektur mit einem differentiellen Tastkopf mit zwei in Basisschaltung betriebenen bipolaren Pufferstufen und einem differentiellen Verstärker. Dabei sind Kompensationsnetzwerke vorhanden, welche die Nullstelle des Spitzennetzwerks kompensieren sollen.

US 6 483 284 B1 offenbart ein Tastkopf-System gemäß der Präambel des Anspruchs 1.

Der Erfindung liegt somit die Aufgabe zugrunde, ein Tastkopf-System mit einer verbesserten Gleichtaktunterdrückung zu schaffen, welche über den gesamten Frequenzbereich möglichst homogen wirkt.

Die Aufgabe wird durch die Merkmale des Anspruchs 1 gelöst. Die abhängigen Ansprüche enthalten vorteilhafte Weiterbildungen der Erfindungen.

Erfindungsgemäß wird zumindest ein Kompensationsnetzwerk ausgangsseitig des differentiellen Verstärkers oder in einem einen Ausgang mit einem Eingang des differentiellen Verstärkers verbindenden Rückkopplungspfand angeordnet. Im Gegensatz zu der aus dem Stand der Technik bekannten eingangsseitigen Anordnung des Kompensationsnetzwerkes hat dies den Vorteil einer wesentlich besseren Gleichtaktunterdrückung. Während beim Stand der Technik die beiden Eingangsströme einzeln massebezogen voneinander unabhängig den Kompensationsnetzwerken zugeführt werden und erst danach die Differenzbildung auf Spannungsebene stattfindet, wird bei der Erfindung zunächst die Differenz der Eingangsströme gebildet und erst dann die Differenz der Eingangsströme dem zumindest einen Kompensationsnetzwerk ausgangsseitig des Verstärkers zugeführt. Während beim Stand der Technik die Gleichtaktströme direkt als Gleichtaktaussteuerungen an den Differenzverstärker weitergeleitet werden, werden bei der Erfindung die Gleichtakt-Eingangssignale schon unterdrückt, bevor sie dem Kompensationsnetzwerk zugeführt werden. Dadurch wird auch die Empfindlichkeit gegenüber Gleichtaktrauschen stark reduziert.

Während beim Stand der Technik schon geringe Unterschiede der beiden eingangsseitigen Kompensationsnetzwerke, wie sie z.B. durch Fertigungstoleranzen entstehen, sofort zu einer Umwandlung von Gleichtaktspannungen in Differenzspannungen führen, ist dieser Effekt bei der erfindungsgemäßen Ausgestaltung stark reduziert, da die Kompensation nach der Differenzbildung stattfindet und nur ein Kompensationsnetzwerk relevant ist. Dadurch können keine Probleme mit Toleranzen wie bei zwei unabhängigen Kompensationsnetzwerken entstehen. Außerdem hat sich gezeigt, dass eine Differenzbildung von Strömen mit einer hohen Linearität über eine große Bandbreite hinweg möglich ist.

Die Ausgestaltung des Eingangsnetzwerks mit zwei Widerständen, wobei nur einer der Widerstände durch einen parallel geschalteten Kondensator überbrückt ist, hat den Vorteil, dass neben einer Nullstelle auch eine Polstelle im Eingangsnetzwerk vorhanden ist. Beim Stand der Technik ist hingegen nur eine Nullstelle vorhanden, da der Serienwiderstand fehlt. Durch die Polstelle wird die Eingangsimpedanz bei hohen Frequenzen im Bereich mehrerer GHz angehoben.

Durch eine entsprechende Ausgestaltung des Kompensationsnetzwerks jedenfalls mit zwei Serienwiderständen und einem zu einem der beiden Serienwiderstände parallel geschalteten Kondensator, wird bei einer geeigneten Dimensionierung eine wechselseitige Kompensation erreicht. Dabei kompensiert die Polstelle des Kompensationsnetzwerks die Nullstelle des Eingangsnetzwerks und die Nullstelle des Kompensationsnetzwerks die Polstelle des Eingangsnetzwerks. Es reicht in der Regel aus, am Ausgang nur ein einziges Kompensationsnetzwerk vorzusehen, bevorzugt an dem Ausgang, an welchem das weiter zu verarbeitende Signal abgenommen wird. Wenn der Verstärker als volldifferenzierender Verstärker mit einem differentiellen Ausgang ausgebildet ist, kann es zur Verbesserung der Symmetrie vorteilhaft sein, auch an dem zweiten invertierten Ausgang ein zweites Kompensationsnetzwerk vorzusehen. Es ist alternativ auch möglich, das Kompensationsnetzwerk statt zwischen jedem Ausgang und der Schaltungsmasse direkt zwischen den beiden Ausgängen anzuordnen, wobei dann vorteilhaft mindestens zwei Serienwiderstände vorgesehen sind und der Kondensator parallel zu einem der Widerstände angeordnet ist.

Statt das Kompensationsnetzwerk zwischen dem Ausgang und der Schaltmasse anzuordnen, ist es alternativ möglich, das Kompensationsnetzwerk in einem Rückkopplungspfad zwischen dem Ausgang und dem zugeordneten Eingang anzuordnen.

Die Erfindung wird nachfolgend unter Bezugnahme auf die in der Zeichnung dargestellten Ausführungsbeispiele beispielhaft näher erläutert. In der Zeichnung zeigen:
- Fig. 1: das Prinzipschaltbild eines ersten Ausführungsbeispiels eines erfindungsgemäßen Tastkopf-Systems;
- Fig. 2: das Prinzipschaltbild eines zweiten Ausführungsbeispiels des erfindungsgemäßen Tastkopf-Systems;
- Fig. 3: das Prinzipschaltbild eines dritten Ausführungsbeispiels des erfindungsgemäßen Tastkopf-Systems und
- Fig. 4: das Prinzipschaltbild eines vierten Ausführungsbeispiels des erfindungsgemäßen Tastkopf-Systems.

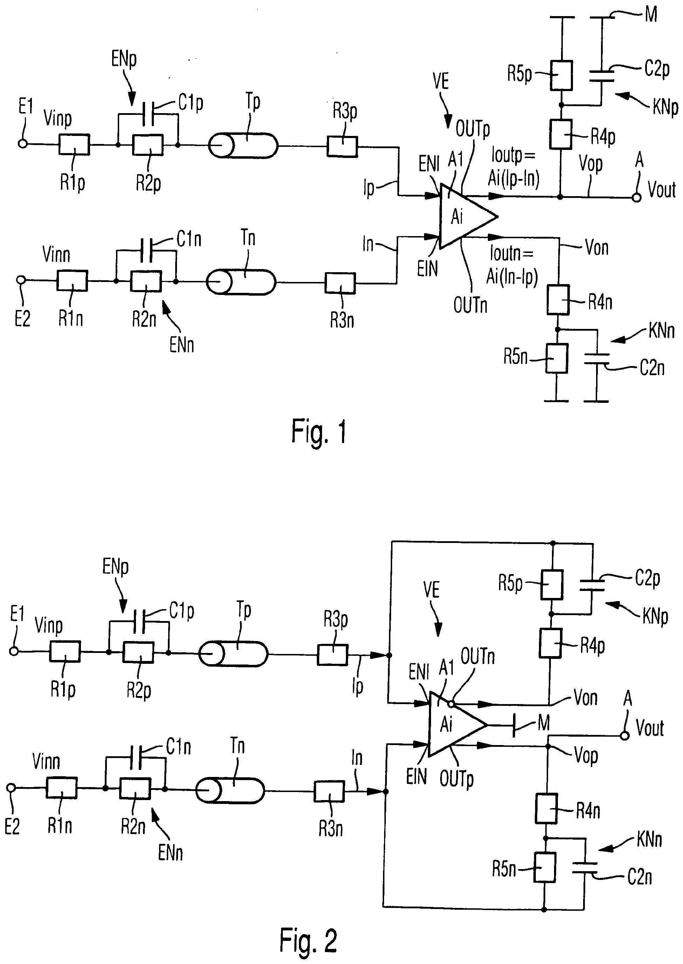

Fig. 1 zeigt ein erstes Ausführungsbeispiel des erfindungsgemäßen Tastkopf-Systems. Das erfindungsgemäße Tastkopf-System dient insbesondere als Tastkopf für ein Oszilloskop, es kann jedoch auch in anderer Weise eingesetzt werden.

An einem Eingangsanschluss E1 liegt die Spannung Vinp eines Eingangssignals an. Im Ausführungsbeispiel durchläuft dieses Eingangssignal Vinp zunächst einen ersten Widerstand R1p und einen zweiten Widerstand R2p, bevor es an eine Übertragungsleitung Tp gelangt. Bei dieser Übertragungsleitung Tp kann es sich beispielsweise um eine Koaxial-Leitung handeln. Es sind aber auch Flachbandleitungen oder Streifenleitungen, insbesondere Koplanar-Leitungen möglich. Mittels der Übertragungsleitung Tp wird das Signal über eine gewisse räumliche Distanz bis zu einer Verstärkungseinheit VE transportiert.

In der Verstärkereinheit VE gelangt das Eingangssignal dann über einen dritten Widerstand R3p an den Eingang ENI eines differentiellen Verstärkers A1. Der Eingangswiderstand dieses Verstärkers A1 ist bevorzugt niederohmig ausgelegt, sodass ein nennenswerter Strom IP in den Eingang des Verstärkers A1 hinein fließt. Der Verstärker A1 ist bevorzugt als differentieller Stromverstärker ausgelegt, d.h. sein Ausgangsstrom Ioutn bzw. Ioutp ist proportional zur Differenz der Eingangsströme Ip, In.

Der zweite Widerstand R2p ist im bevorzugten Ausführungsbeispiel durch einen ersten Kondensator C1p überbrückt, indem dieser Kondensator C1p parallel zu diesem Widerstand R2p geschaltet ist. Damit ist der Widerstand R2p für die hochfrequenten Signalanteile des Eingangssignals Vinp, d.h. für die hochfrequente SignalKomponente, überbrückt und nicht wirksam. Die Widerstände R1p und R2p bilden zusammen mit dem Kondensator ein Eingangsnetzwerk ENp.

Am ersten Ausgang OUTp des ersten Verstärkers A1 ist ein erstes Kompensationsnetzwerk KNp bestehend aus einem vierten Widerstand R4p, einem fünften Widerstand R5p und einem zweiten Kondensator C2p angeschlossen. Im Ausführungsbeispiel ist das Kompensationsnetzwerk KNp als Parallelschaltung des Widerstands R5p mit dem Kondensator C2p ausgeführt und zwischen dem ersten Ausgangsanschluss OUTp des Verstärkers A1 und der Schaltungsmasse M angeordnet. Im Gegensatz zum Stand der Technik nach US 6,856,126 B2 ist nur ein Kompensationsnetzwerk für die Funktion der Schaltung relevant. Dies hat wesentliche Vorteile. Insbesondere führen unvermeidbare Fertigungstoleranzen zwischen den Kompensationsnetzwerken KNp, KNn, nicht zu einer Umwandlung von Gleichtakt- in Differenz-Signale. Die CMRR (Common Mode Response Ratio, Verhalten bei Gleichtaktansteuerung) ist bei der erfindungsgemäßen Ausgestaltung wesentlich besser.

Das Tastkopf-System ist für differentielle Eingangssignale gedacht, d.h. die Ausgangsspannung Vout am Ausgang A ist abhängig von der Spannungs-Differenz zwischen dem ersten Eingangsanschluss E1 und einem zweiten Eingangsanschluss E2 bzw. der Strom-Differenz Ip-In zwischen den Eingängen ENI und EIP des Verstärkers A1. Parallel zum ersten Signalweg für das positive Eingangssignal Vinp gibt es einen zweiten Signalzweig für das negative Eingangssignal Vinn, welches am zweiten Eingangsanschluss E2 anliegt. Dieses negative Eingangssignal Vinn gelangt über einen entsprechenden ersten Widerstand R1n und einen zweiten Widerstand R2n an den Eingangsanschluss einer zweiten Übertragungsleitung Tn. Der zweite Widerstand R2n ist auch hier mit einem entsprechenden ersten Kondensator C1n überbrückt. Vom Ausgang der Übertragungsleitung Tn gelangt das Signal über einen dritten Widerstand R3n an den invertierenden Eingang EIN des Verstärkers A1, der als voll differentieller Verstärker ausgebildet ist.

Der Verstärker A ist hier ein Stromverstärker. Der Ausgangsstrom Ioutp am ersten Ausgang OUTp ist über den Verstärkungsfaktor A1 von der Differenz der Ströme Ip und In am Eingang abhängig. Es gilt Ioutp=Ai^{∗}(Ip-In). Umgekehrt gilt für den Strom Ioutn Von am zweiten Ausgang OUTn: IOutn=Ai^{∗}(In-Ip). Auch im zweiten Signalzweig kann ein Kompensationsnetzwerk KNn vorhanden sein, welches aus einer Parallelschaltung eines fünften Widerstands R5n und eines zweiten Kondensators C2n mit einem zu dieser Parallelschaltung in Serie geschaltenen vierten Widerstand R4n besteht und welches den zweiten invertierenden Ausgang OUTn des Verstärkers A1 mit der Schaltungsmasse M verbindet. Das zweite Kompensationsnetzwerk KNn ist nicht zwingend notwendig und kann auch anstatt des ersten Kompensationsnetzwerks KNp vorgesehen sein. In jedem Fall spielen kleine Unterschiede zwischen KNp und KNn keine Rolle und führen nicht zu einem Ausgangssignal Vout bei Gleichtakt-Ausstellung (Vinp=Vinn).

Fig. 2 zeigt ein zweites Ausführungsbeispiel des erfindungsgemäßen Tastkopf-Systems. Bereits anhand von Fig. 1 beschriebene Schaltungselemente sind mit übereinstimmenden Bezugszeichen versehen und werden anschließend zur Vermeidung von Wiederholungen nicht noch einmal beschrieben. Die nachfolgende Beschreibung geht nur auf die Besonderheiten des zweiten Ausführungsbeispiels ein.

Im dargestellten zweiten Ausführungsbeispiel ist der Verstärker A2 als voll-differentieller Operationsverstärker ausgebildet.

Im Gegensatz zum in Fig. 1 dargestellten ersten Ausführungsbeispiel ist bei dem in Fig. 2 dargestellten zweiten Ausführungsbeispiel das Kompensationsnetzwerk KNp bzw. KNn nicht zwischen dem Ausgang OUTp bzw. OUTn und der Schaltungsmasse M, sondern zwischen dem invertierten Ausgang OUTn des voll-differenziellen Operationsverstärkers A2 und einem nicht invertierenden Eingang ENI des Verstärkers A2 bzw. zwischen dem nicht invertierten Ausgang OUTp und dem invertierenden Eingang EIN ausgebildet.

Auch bei dem in Fig. 2 dargestellten Ausführungsbeispiel ist das Kompensationsnetzwerk KNp als Parallelschaltung eines fünften Widerstands R5p und eines zweiten Kondensators C2p in Verbindung mit einem zu dieser Parallelschaltung in Serie geschaltenen vierten Widerstand R4p ausgeführt. Diese Schaltung verbindet den Ausgang OUTn des Verstärkers A2 mit seinem nicht invertierenden Eingang ENI. In gleicher Weise ist das Kompensationsnetzwerk KNn ausgebildet, welches den Ausgang OUTp des Verstärkers A2 mit seinem invertierenden Eingang EIN verbindet. Die in Fig. 2 dargestellte Schaltung ist im Wesentlichen funktional äquivalent zu der in Fig. 1 dargestellten Schaltung.

Die Widerstände R1, R2 und der Kondensator C1 erzeugen jeweils eine Nullstelle und eine erste Polstelle im Frequenzgang. Typische Werte liegen bei R2n=R2p=50kOhm. Ein bevorzugter Wertebereich liegt zwischen 5 kOhm und 100 kOhm. Ein typischer Wert für R1p=R1n liegt bei 450 Ohm. Ein vernünftiger Wertebereich liegt zwischen 50 Ohm und 1 kOhm. Ein typischer Wert für den ersten Kondensator liegt bei C1p=C1n=0,2 pF. Ein bevorzugter Wertebereich liegt zwischen 0,1 pF und 1 pF. Ein typischer Wert für den dritten Widerstand R3p=R3n liegt bei 50 Ohm. Der bevorzugte Wertebereich liegt hier zwischen 10 Ohm und 100 Ohm. Ein typischer Werte für den vierten Widerstand R4p=R4n liegt beispielsweise bei 5050 Ohm. Ein bevorzugter Wertebereich liegt zwischen 1 kOhm und 10 kOhm. Ein typischer Wert für die Kapazität des zweiten Kompensators C2p=C2n liegt bei 2 pF. Ein bevorzugter Wertebereich hierfür liegt zwischen 0,5 pF und 5 pF.

Die Widerstände R3p und R3n dienen dazu, die Übertragungsleitungen Tp und Tn wellenwiderstandsrichtig abzuschließen. Für den Verstärker A1, welcher eine niedrigere Eingangsimpdedanz bis zu hohen Frequenzen aufweisen sollte, kommen so genannte Transimpedanz-Operationsverstärker in Betracht.

Mit den Kompensationsnetzwerken KNn und KNp bestehend aus den Widerständen R4p, R5p und R4n, R5n und den Kondensatoren C2p und C2n wird eine zweite Nullstelle und eine zweite Polstelle im Frequenzgang erzeugt, wobei die Frequenz der zweiten Polstelle gleich der Frequenz der ersten Nullstelle und die Frequenz der zweiten Nullstelle gleich der Frequenz der ersten Polstelle ist.

Die Übertragungsleitungen Tp und Tn sind über den gesamten Frequenzbereich richtig abgeschlossen, sodass keine störende Welligkeit im Frequenzgang entsteht. Der Eingangswiderstand der Schaltung bei Gleichspannung entspricht der Summe der Widerstände R1+R2+R3 und ist damit sehr hoch. Das eingangsseitig der Übertragungsleitung TP bzw. Tn angeordnete EingangsNetzwerk ENp bzw. ENn in der Nähe der Tastspitze ist sehr viel kleiner als das Verstärkermodul VE und kann sehr einfach an schwer zugänglichen Stellen innerhalb eines Tastkopfes angeordnet werden.

Die vorstehend genannten Wertebereiche und Erläuterungen gelten nicht nur für das Ausführungsbeispiel der Fig.2 , sondern für alle Ausführungsbeispiele.

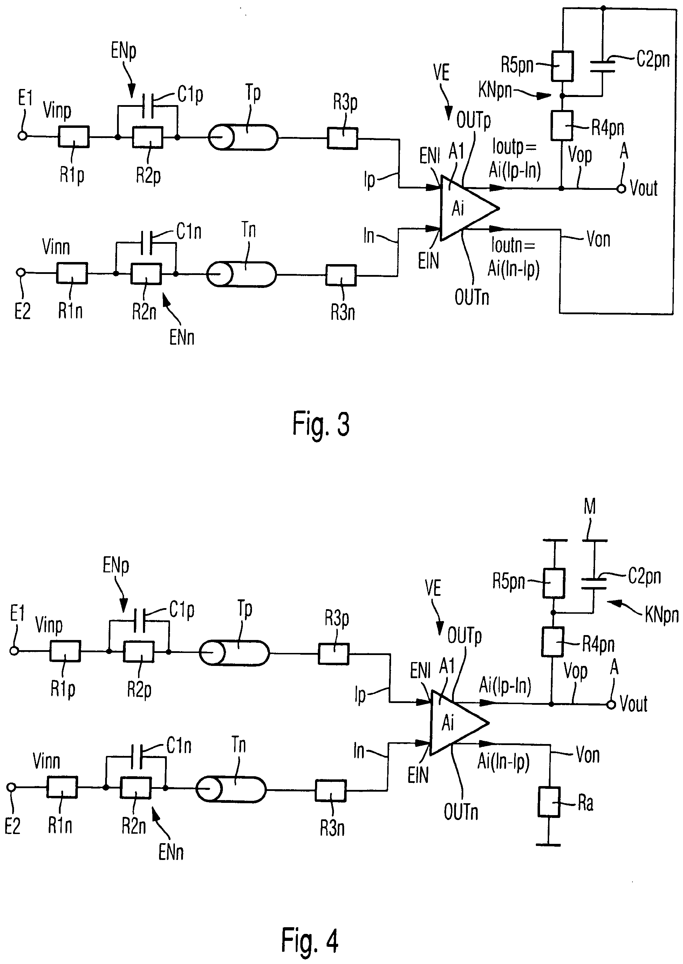

Fig. 3 zeigt ein weiteres alternatives Ausführungsbeispiel. Bei diesem Ausführungsbeispiel ist im Gegensatz zu Fig. 1 nicht jeweils ein Kompensationsnetzwerk KNp zwischen dem Ausgang OUTp und der Schaltungsmasse M und ein zweites Kompensationsnetzwerk KNn zwischen dem Ausgang OUTn und der Schaltungsmasse M vorgesehen, sondern es ist ein gemeinsames Kompensationsnetzwerk KNpn vorhanden, welches zwischen den beiden Ausgängen OUTp und OUTn angeordnet ist. Wegen der Symmetrie zur Schaltungsmasse ist eine Verbindung zu der Schaltungsmasse nicht erforderlich. Dieses Kompensationsnetzwerk KNpn besteht zweckmäßigerweise aus zwei in Serie geschalteten Widerständen R4pn, R5pn. Der Kondensator C2pn ist dann zweckmäßigerweise parallel zu dem Widerstand R5pn geschaltet. In diesem Ausführungsbeispiel ist die Ausgangsspannung Vout die Differenz der beiden Ausgangsspannungen Vop,Von : Vout=Vop-Von.

Fig. 4 zeigt ein viertes Ausführungsbeispiel des erfindungsgemäßen Tastkopf-Systems. Dieses Ausführungsbeispiel unterscheidet sich von dem in Fig. 1 dargestellten Ausführungsbeispiel dadurch, dass auf das zweite Kompensationsnetzwerk KNn an dem für die Weiterverarbeitung des Signals nicht benutzten Ausgang OUTn verzichtet wird. Stattdessen wird der Ausgang OUTn, aus welchem die mit dem Verstärkungsfaktor Ai multiplizierte Differenz der Ströme In-Ip fließt, durch einen Abschlusswiderstand Ra abgeschlossen. Dieser Abschlusswiderstand Ra verbindet den Ausgang OUTn mit der Schaltungsmasse M. In ähnlicher Weise könnte auch das in Fig. 2 dargestellte Ausführungsbeispiel modifiziert werden, indem dort das zweite Kompensationsnetzwerk KNn weggelassen wird.

Nur ein Kompensationsnetzwerk KNp ist deshalb ausreichend, weil es auf den Ausgangsstrom wirkt, welcher über dem Verstärkungsfaktor Ai von der Differenz Ip-In beider Eingangsströme Ip als auch In abhängig ist. Somit wirkt das Kompensationsnetzwerk KNp beiden Eingangsnetzwerken ENp und ENn entgegen. Um einerseits die Schaltung zu vereinfachen und andererseits die Auswirkung von Bauteiletoleranzen auf die genaue Lage der zweiten Nullstelle und der zweiten Polstelle der Kompensationsnetzwerke zu vermeiden, ist es sogar vorteilhaft, nur ein Kompensationsnetzwerk KNp zu verwenden. Dieses ist zweckmäßigerweise an dem Ausgang OUTp angeordnet, an welchem die Ausgangsspannung Vout über den Ausgangsanschluss A abgenommen wird. Grundsätzlich könnte das nur eine Kompensationsnetzwerk KNn aber auch an dem anderen Ausgang OUTn angeordnet sein und das Kompensationsnetz KNp könnte dann entfallen.

Die Ausgestaltung nach Fig. 4 kann auch eingesetzt werden, wenn der differentielle Verstärker A1 nur einen einzigen Ausgang hat, also beispielsweise nur den Ausgang OUTp, dessen Ausgangsstrom Ioutp nur von der Differenz der Ströme Ip-In abhängig ist, nicht aber den Ausgang OUTn, dessen Ausgangsstrom Ioutn von der Differenz der Ströme In-Ip abhängig ist.

Die Ausgangsspannung Vout kann auch weiter gepuffert werden, um sie über einen weiteren Wellenleiter einem Messgerät zuzuführen. Die Spannungen Vop und Von können auch direkt einem Messgerät mit differentiellem Eingang zugeführt werden. Um die Restwelligkeit aufgrund von mehrfacher Reflexionen auf den Wellenleiter Tp und Tn weiter zu verbessern, können die Wellenleiter Tp und Tn auch eingangsseitig mit einem Widerstand in der Größenordnung der Widerstandswerte der Widerstände R3p und R3n abgeschlossen werden. Stattdessen ist es auch denkbar, einen Widerstand der Größe 2^{∗}R3p=2^{∗}R3n zwischen den Eingängen der Wellenleiter Tp und Tn zu schalten.

Wie bereits erwähnt, ist die Ausgangsspannung Vout am Ausgang A proportional zur Differenz der Eingangsspannungen, also proportional zu Vinp-Vinn. Sind die Grenzfrequenzen der Pol- und Nullstellen des Kompensationsnetzwerks bzw. der Kompensationsnetzwerke richtig gewählt, ist die Verstärkung Vout/(Vinp-Vinn) zumindest nahezu frequenzunabhängig. Sind die Wellenleiter über den ganzen Frequenzbereich richtig abgeschlossen, so entsteht keine Störung der Welligkeit im Frequenzgang. Der Eingangswiderstand der Schaltung bei Gleichspannung entspricht der Summe aus den Widerstandswerten von R1p+R2p+R3p=R1n+R2n+R3n. Der Eingangswiderstand ist daher sehr hoch.

Die Erfindung ist nicht auf die dargestellten Ausführungsbeispiele beschränkt. Beispielsweise kann das Kompensationsnetzwerk auch aufgeteilt werden, wobei ein erster Teil des Kompensationsnetzwerks jeweils in dem Rückkopplungspfad liegt und ein anderer Teil des Kompensationsnetzwerkes lastseitig des Verstärkers angeordnet ist.

## Patentansprüche

1. Tastkopf-System zum Erfassen eines differentiellen Eingangssignals mit
einem ersten Eingangsnetzwerk (ENp), das mit einer ersten Komponente (Vinp) des differentiellen Eingangssignals beaufschlagt ist, zur Erzeugung eines ersten Zwischensignals (Ip),
einem zweiten Eingangsnetzwerk (ENn), das mit einer zweiten Komponente (Vinn) des differentiellen Eingangssignals beaufschlagt ist, zur Erzeugung eines zweiten Zwischensignals (In),
einem in Signalflussrichtung hinter den Eingangsnetzwerken (ENp, ENn) angeordneten differentiellen Verstärker (A1) zum Verstärken der Differenz der Zwischensignale (Ip,In) und
zumindest einem Kompensationsnetzwerk (KNp, KNn; KNpn) zur Kompensation des Einflusses der Eingangsnetzwerke (ENp, ENn) auf die Komponenten (Vinp, Vinn) des differentiellen Eingangssignals,
**dadurch gekennzeichnet,**
**dass** das zumindest eine Kompensationsnetzwerk (KNp, KNn; KNpn) ausgangsseitig des differentiellen Verstärkers (A1) angeordnet ist,
**dass** jedes Eingangsnetzwerk (ENp; ENn) aus einer Serienschaltung eines ersten Widerstands (R1p; R1n) und eines zweiten Widerstands (R2p; R2n) und aus einem ersten Kondensator (C1p; C1n), der dem zweiten Widerstand (R2p; R2n) parallel geschaltet ist, besteht, und
**dass** jedes Kompensationsnetzwerk (KNp; KNn) aus einer Serienschaltung eines vierten Widerstands (R4p; R4n) und eines fünften Widerstands (R5p; R5n) und aus einem zweiten Kondensator (C2p; C2n; C2pn), der dem fünften Widerstand (R5p; R5n) parallel geschaltet ist, besteht.

2. Tastkopf-System nach Anspruch 1,
**gekennzeichnet durch**
eine in Signalflussrichtung zwischen dem Ausgang des ersten Eingangsnetzwerks (ENp) und einem ersten Eingang (ENI) des differentiellen Verstärkers (A1) angeschlossene ersten Übertragungsleitung (Tp) zur Übertragung der ersten Komponente (Vinp) des differentiellen Eingangssignals und/oder
eine in Signalflussrichtung zwischen dem Ausgang des zweiten Eingangsnetzwerks (ENn) und einem zweiten Eingang (EIN) des differentiellen Verstärkers (A1) angeschlossene zweite Übertragungsleitung (Tn) zur Übertragung der zweiten Komponente (Vinn) des differentiellen Eingangssignals.

3. Tastkopf-System nach Anspruch 2,
**dadurch gekennzeichnet,**
**dass** zwischen jeder Übertragungsleitung (Tn; Tp) und einem zugehörigen Eingang (ENI; EIN) des differentiellen Verstärkers (A1) ein dritter Widerstand (R3p; R3n) angeordnet ist, welcher die jeweilige Übertragungsleitung (Tn; Tp) mit einem passenden Abschlusswiderstandswert abschließt.

4. Tastkopf-System nach einem der Ansprüche 1 bis 3,
**dadurch gekennzeichnet,**
**dass** ein erstes des zumindest einen Kompensationsnetzwerks (KNp) zwischen einem ersten Ausgang (OUTp) des differentiellen Verstärkers (A1) und der Schaltungsmasse (M) angeordnet ist und/oder dass ein zweites des zumindest einen Kompensationsnetzwerks (KNn) zwischen einem zweiten Ausgang (OUTn) des differentiellen Verstärkers (A1) und der Schaltungsmasse (M) angeordnet ist.

5. Tastkopf-System nach einem der Ansprüche 1 bis 3,
**dadurch gekennzeichnet,**
**dass** ein erstes des zumindest einen Kompensationsnetzwerks (KNp) an einem ersten Ausgang (OUTn) des differentiellen Verstärkers (A1) so angeordnet ist, dass es den ersten Ausgang (OUTn) des differenziellen Verstärkers (A1) mit einen nicht invertierenden Eingang (ENI) verbindet,
und/oder
**dass** ein zweites des zumindest einen Kompensationsnetzwerks (KNn) an einem zweiten Ausgang (OUTp) des differentiellen Verstärkers (A1) so angeordnet ist, dass es den zweiten Ausgang (OUTp) des differentiellen Verstärkers (A1) mit einen invertierenden Eingang (EIN) verbindet.

6. Tastkopf-System nach Anspruch 3,
**dadurch gekennzeichnet,**
**dass** das gemeinsame Kompensationsnetzwerk (KNpn) zwischen einem ersten Ausgang (OUTp) und einem zweiten Ausgang (OUTn) des differentiellen Verstärkers (A1) angeordnet ist.

7. Tastkopf-System nach Anspruch 6,
**dadurch gekennzeichnet,**
**dass** das gemeinsame Kompensationsnetzwerk (KNpn) aus einer Serienschaltung aus den drei Widerständen (R4p; R5pn; R4n) und aus dem zweiten Kondensator (C2pn), der dem mittleren der drei Widerstände (R4p; R5pn; R4n) parallel geschaltet ist, besteht.

8. Tastkopf-System nach einem der Ansprüche 1 bis 7,
**dadurch gekennzeichnet,**
**dass** jedes Eingangsnetzwerk (ENp; ENn) jeweils eine erste Nullstelle und eine erste Polstelle in seiner Übertragungsfunktion aufweist und
**dass** jedes Kompensationsnetzwerk (KNp; KNp; KNpn) jeweils eine zweite Nullstelle und eine zweite Polstelle in seiner Übertragungsfunktion aufweist,
wobei die zweite Nullstelle jedes Kompensationsnetzwerks (KNp; KNp; KNpn) eine Polstelle zumindest eines Eingangsnetzwerks (ENp; ENn) und die zweite Polstelle jedes Kompensationsnetzwerks (KNp; KNp; KNpn) eine Nullstelle zumindest eines Eingangsnetzwerks (ENp; ENn) kompensiert.

9. Tastkopf-System nach einem der Ansprüche 1 bis 8,
**dadurch gekennzeichnet,**
**dass** der differenzielle Verstärker (A1) über niederohmige Eingänge verfügt, und dass er über mindestens einen Ausgang verfügt, dessen Ausgangssignal proportional zur Differenz der beiden Eingangsströme ist.

10. Tastkopf-System nach einem der Ansprüche 1 bis 9,
**dadurch gekennzeichnet,**
**dass** der differenzielle Verstärker (A2) über einen nichtinvertierenden Ausgang (OUTp) und einen invertierenden Ausgang (OUTn) verfügt.

## Claims

1. A probe system for the registration of a differential input signal with
a first input network (ENp), which is supplied with a first component (Vinp) of the differential input signal in order to generate a first intermediate signal (Ip),
a second input network (ENn), which is supplied with a second component (Vinn) of the differential input signal in order to generate a second intermediate signal (In),
a differential amplifier (A1) arranged downstream of the input networks (ENp, ENn) in the signal-flow direction for the amplification of the difference between the intermediate signals (Ip,In) and
at least one compensation network (KNp, KNn; KNpn) for the compensation of the influence of the input networks (ENp, ENn) on the components (Vinp, Vinn) of the differential input signal,
**characterised in that**
the at least one compensation network (KNp, KNn; KNpn) is arranged at the output end of the differential amplifier (A1),
that each input network (ENp; ENn) comprises a series circuit of a first resistor (R1p; R1n) and a second resistor (R2p; R2n) and a first capacitor (C1p; C1n), which is connected in parallel to the second resistor (R2p; R2n), and
that each compensation network (KNp; KNn) comprises a series connection of a fourth resistor (R4p; R4n) and a fifth resistor (R5p; R5n) and a second capacitor (C2p; C2n; C2pn), which is connected in parallel to the fifth resistor (R5p; R5n).

2. The probe system according to claim 1,
**characterised by**
a first transmission line (Tp) for the transmission of the first component (Vinp) of the differential input signal connected in the signal flow direction between the output of the first input network (ENp) and a first input (ENI) of the differential amplifier (A1)
and/or
a second transmission line (Tn) for the transmission of the second component (Vinn) of the differential input signal connected in the signal flow direction between the output of the second input network (ENn) and a second input (EIN) of the differential amplifier (A1).

3. The probe system according to claim 2,
**characterised in that**
a third resistor (R3p; R3n), which terminates the respective transmission line (Tn; Tp) with a matching terminal resistance value, is arranged between each transmission line (Tn; Tp) and an associated input (ENI; EIN) of the differential amplifier (A1).

4. The probe system according to any one of claims 1 to 3,
**characterised in that**
a first of said at least one compensation network (KNp) is arranged between a first output (OUTp) of the differential amplifier (A1) and the circuit ground (M) and/or
that a second of said at least one compensation network (KNn) is arranged between the second output (OUTn) of the differential amplifier (A1) and the circuit ground (M).

5. The probe system according to any one of claims 1 to 3,
**characterised in that**
a first of said at least one compensation network (KNp) is arranged at a first output (OUTn) of the differential amplifier (A1) in a manner that it connects the first output (OUTn) of the differential amplifier (A1) with a non-inventing input (ENI) and/or
that a second of said at least one compensation network (KNn) is arranged at a second output (OUTp) of the differential amplifier (A1) in a manner that it connects the second output (OUTp) of the differential amplifier (A1) with an inventing input (EIN).

6. The probe system according to any one of claim 3,
**characterised in that**
the common compensation network (KNpn) is arranged between a first output (OUTp) and a second output (OUTn) of the differential amplifier (A1).

7. The probe system according to claim 6,
**characterised in that**
the common compensation network (KNpn) comprises a series circuit of the three resistors (R4p; R5pn; R4n) and the second capacitor (C2pn), which is connected in parallel to the middle one of the three resistors (R4p; R5pn; R4n).

8. The probe system according to any one of claims 1 to 7,
**characterised in that**
each input network (ENp; ENn) provides respectively a first zero and a first pole in its transmission function and that each compensation network (KNp; KNp; KNpn) provides respectively a second zero and a second pole in its transmission function,
wherein the second zero of each compensation network (KNp; KNp; KNpn) compensates a pole of at least one input network (ENp; ENn), and the second pole of each compensation network (KNp; KNp; KNpn) compensates a zero of at least one input network (ENp; ENn).

9. The probe system according to any one of claims 1 to 8,
**characterised in that**
the differential amplifier (A1) provides low-ohmic inputs, and that it provides at least one output, of which the output signal is proportional to the difference between the two input currents.

10. The probe system according to any one of claims 1 to 9,
**characterised in that**
the differential amplifier (A2) provides a non-inverting output (OUTp) and an inverting output (OUTn).

## Revendications

1. Système de sonde destiné à détecter un signal d'entrée différentiel, pourvu
d'un premier réseau d'entrée (ENp), auquel est appliquée une première composante (Vinp) du signal d'entrée différentiel, pour produire un premier signal intermédiaire (Ip),
d'un deuxième réseau d'entrée (ENn), auquel est appliquée une deuxième composante (Vinn) du signal d'entrée différentiel, pour produire un deuxième signal intermédiaire (In),
d'un amplificateur différentiel (A1), destiné à amplifier la différence des signaux intermédiaires (Ip, In), agencé derrière les réseaux d'entrée (ENp, ENn) dans le sens de flux du signal et
d'au moins un réseau de compensation (KNp, KNn ; KNpn) destiné à compenser l'influence du réseau d'entrée (ENp, ENn) sur les composantes (Vinp, Vinn) du signal d'entrée différentiel,
**caractérisé**
**en ce que** le au moins un réseau de compensation (KNp, KNn ; KNpn) est agencé côté sortie de l'amplificateur différentiel (A1),
**en ce que** chaque réseau d'entrée (ENp ; ENn) est constitué d'un montage en série d'une première résistance (R1p ; R1n) et d'une deuxième résistance (R2p ; R2n) et d'un premier condensateur (C1p ; C1n), qui est monté parallèlement à la deuxième résistance (R2p ; R2n), et
**en ce que** chaque réseau de compensation (KNp ; KNn) est constitué d'un montage en série d'une quatrième résistance (R4p ; R4n) et d'une cinquième résistance (R5p ; R5n) et d'un deuxième condensateur (C2p ; C2n ; C2pn), qui est monté parallèlement à la cinquième résistance (R5p ; R5n).

2. Système de sonde selon la revendication 1,
**caractérisé par**
une première ligne de transmission (Tp) raccordée dans le sens de flux du signal entre la sortie du premier réseau d'entrée (ENp) et une première entrée (ENI) de l'amplificateur différentiel (A1) pour la transmission de la première composante (Vinp) du signal d'entrée différentiel et/ou
une deuxième ligne de transmission (Tn) raccordée dans le sens de flux du signal entre la sortie du deuxième réseau d'entrée (ENn) et une deuxième entrée (EIN) de l'amplificateur différentiel (A1) pour la transmission de la deuxième composante (Vinn) du signal d'entrée différentiel.

3. Système de sonde selon la revendication 2,
**caractérisé**
**en ce qu'**une troisième résistance (R3p ; R3n), laquelle ferme la ligne de transmission (Tn ; Tp) respective au moyen d'une valeur de résistance de terminaison adaptée, est agencée entre chaque ligne de transmission (Tn ; Tp) et une entrée (ENI ; EIN) correspondante de l'amplificateur différentiel (A1).

4. Système de sonde selon l'une quelconque des revendications 1 à 3,
**caractérisé**
**en ce qu'**un premier du au moins un réseau de compensation (KNp) est agencé entre une première sortie (OUTp) de l'amplificateur différentiel (A1) et la masse de circuit (M) et/ou
**en ce qu'**un deuxième du au moins un réseau de compensation (KNn) est agencé entre une deuxième sortie (OUTn) de l'amplificateur différentiel (A1) et la masse de circuit (M).

5. Système de sonde selon l'une quelconque des revendications 1 à 3,
**caractérisé**
**en ce qu'**un premier du au moins un réseau de compensation (KNp) est agencé au niveau d'une première sortie (OUTn) de l'amplificateur différentiel (A1) de sorte qu'il relie la première sortie (OUTn) de l'amplificateur différentiel (A1) à une entrée non inverseuse (ENI), et/ou
**en ce qu'**un deuxième du au moins un réseau de compensation (KNn) est agencé au niveau d'une deuxième sortie (OUTp) de l'amplificateur différentiel (A1), de sorte qu'il relie la deuxième sortie (OUTp) de l'amplificateur différentiel (A1) à une entrée inverseuse (EIN).

6. Système de sonde selon la revendication 3,
**caractérisé**
**en ce que** le réseau de compensation (KNpn) commun est agencé entre une première sortie (OUTp) et une deuxième sortie (OUtn) de l'amplificateur différentiel (A1).

7. Système de sonde selon la revendication 6,
**caractérisé**
**en ce que** le réseau de compensation (KNpn) commun est constitué d'un montage en série composé des trois résistances (R4p ; R5pn ; R4n) et du deuxième condensateur (C2pn), qui est monté parallèlement à la résistance centrale parmi les trois résistances (R4p ; R5pn ; R4n).

8. Système de sonde selon l'une quelconque des revendications 1 à 7,
**caractérisé**
**en ce que** chaque réseau d'entrée (ENp ; ENn) présente respectivement un premier point zéro et un premier point polaire dans sa fonction de transmission et
**en ce que** chaque réseau de compensation (KNp ; KNp ; KNpn) présente respectivement un deuxième point zéro et un deuxième point polaire dans sa fonction de transmission,
dans lequel le deuxième point zéro de chaque réseau de compensation (KNp ; KNp ; KNpn) compense un point polaire au moins d'un réseau d'entrée (ENp ; ENn) et le deuxième point polaire de chaque réseau de compensation (KNp ; KNp ; KNpn) compense un point zéro d'au moins un réseau d'entrée (ENp ; ENn).

9. Système de sonde selon l'une quelconque des revendications 1 à 8,
**caractérisé**
**en ce que** l'amplificateur différentiel (A1) dispose d'entrées de faible impédance, et en ce qu'il dispose d'au moins une sortie, dont le signal de sortie est proportionnel à la différence des deux courants d'entrée.

10. Système de sonde selon l'une quelconque des revendications 1 à 9,
**caractérisé**
**en ce que** l'amplificateur différentiel (A2) dispose d'une sortie non inverseuse (OUTp) et d'une sortie inverseuse (OUTn).
